# EUROPEAN PATENT APPLICATION

(11) **EP 3 319 183 A2**
(43) Date of publication of application: **09.05.2018**
(21) Application number: 17199920.4
(22) Date of filing: 03.11.2017
(51) Int. Cl.: H01R 24/54

(54) **ADAPTER, RECEPTACLE AND CONNECTOR ASSEMBLY**

(30) Priority: 03.11.2016 CN 201610971286
(71) Applicant: Tyco Electronics (Shanghai) Co. Ltd., Shanghai (CN)
(72) Inventor: SONG, Zhigang, Shanghai (CN); NI, Lin, Shanghai (CN); CHEN, Jlahui, Shanghai (CN); WANG, Yunhe, Shanghai (CN); LIU, Songhua, Shanghai (CN)
(74) Representative: Grünecker Patent- und Rechtsanwälte PartG mbB

(57) **Abstract**

The present disclosure discloses a connector assembly including an adaptor and a first receptacle. The adaptor includes an outer conductor, a center conductor and an insulator. The first receptacle includes a first outer terminal, a first center terminal and a first insulation body. The first outer terminal is formed with a first annular protrusion on an outer wall of one end thereof, and the annular protrusion is adapted to be in electrical contact with an inner wall of the outer conductor of the adaptor. Further, the outer conductor of the adaptor and the first outer terminal of the first receptacle are in electrical contact with each other only through the annular protrusion. Therefore, it is possible to reduce electrical contact area between the outer conductor of the adaptor and the outer terminal of the receptacle.

## Description

### CROSS-REFERENCE TO RELATED APPLICATION

This application claims the benefit of Chinese Patent Application No.CN201610971286.7 filed on November 3, 2016 in the State Intellectual Property Office of China, the whole disclosure of which is incorporated herein by reference.

### BACKGROUND OF THE INVENTION

### Field of the Invention

The present disclosure relates to an electrical connector assembly, in particular to a connector assembly having an adaptor to connect two circuit boards.

### Description of the Related Art

In the prior art, a radio frequency coaxial connector assembly for connecting a PCB (Print Circuit Board) to another PCB typically comprises two receptacles and one adaptor. Each receptacle generally comprises a cylindrical outer terminal, a column center terminal, an insulation body and an insulation housing. The center terminal is disposed in the outer terminal, and the insulation body is disposed between the center terminal and the outer terminal to support the center terminal and electrically isolate the center terminal from the outer terminal. The outer terminal is accommodated and positioned in the insulation housing.

The adapter generally comprises a cylindrical outer conductor, a column center conductor and an insulator. The center conductor is disposed in the outer conductor and the insulator is disposed between the center conductor and the outer conductor to support the center conductor and electrically isolate the center conductor from the outer conductor.

Both ends of the adapter are adapted to be mated with the two receptacles, respectively. In the prior art, one end of the adapter is locked and engaged with one receptacle, and the other end of the adapter is slidably engaged with the other receptacle. In order to lock and engage the one end of the adapter with the one receptacle, two technical solutions are typically proposed in the prior art:
(1) one technical solution is to assembly the cylindrical outer conductor (or referred as a metal housing) of the adapter with the outer terminal of the one receptacle in an interference fit manner so as to lock the one end of the adapter with the one receptacle. According to the one technical solution, a contact area between the cylindrical outer conductor of the adapter and the outer terminal of the receptacle is too large, even if there is a multi-point contact in an axial direction of the connector assembly, which reduces the mutual adjustment performance.
(2) the other technical solution is to assembly the insulation body of the adapter with the insulator of the one receptacle in an interference fit manner so as to lock the one end of the adapter with the one receptacle. According to the other technical solution, engagement strength between the insulator and the insulation body is not sufficient to provide sufficient mechanical retention, which causes the one end of the adapter to be easily separated from the receptacle.

### SUMMARY OF THE INVENTION

At least one embodiment of the present disclosure provides a connector assembly capable of improving inter-adjustment performance of the connector assembly.

The present disclosure further provides a connector assembly which can ensure one end of an adaptor and a receptacle are reliably locked together.

According to one aspect of the disclosure, there is provided a connector assembly comprising an adaptor and a first receptacle adapted to be assembled onto one end of the adaptor. The adaptor comprises a cylindrical outer conductor, a column center conductor disposed in the outer conductor, and an insulator disposed between the outer conductor and the center conductor to electrically isolate the outer conductor from the center conductor. The first receptacle comprises a cylindrical first outer terminal, a column first center terminal disposed in the first outer terminal, and a first insulation body disposed between the first outer terminal and the first center terminal to electrically isolate the first outer terminal from the first center terminal. The first outer terminal is formed with a first annular protrusion on an outer wall of the one end thereof, the annular protrusion being adapted to be in electrical contact with an inner wall of the outer conductor of the adaptor. The outer conductor of the adaptor and the first outer terminal of the first receptacle are in electrical contact with each other only through the first annular protrusion.

According to exemplary embodiment of the disclosure, the first receptacle is adapted to be locked onto the one end of the adaptor.

According to another exemplary embodiment of the disclosure, the outer conductor of the adaptor is formed with a recess in an inner wall of one end thereof, and the first annular protrusion on the outer terminal of the first receptacle is adapted to be elastically snap-fit into the recess to lock the first receptacle onto the one end of the adaptor.

According to yet another exemplary embodiment of the disclosure, the insulator of the adaptor is formed with a cylindrical extending portion and an annular protrusion formed on the cylindrical extending portion. The outer terminal is formed with an annular recess in an inner wall of the one end thereof, and the annular protrusion is adapted to be elastically snap-fit into the annular recess to lock the first receptacle onto the one end of the adaptor.

According to still another exemplary embodiment of the disclosure, the annular protrusion on the one end of the first outer terminal is opposite to the annular recess in a radial direction of the first outer terminal. Further, the annular protrusion and the annular recess are simultaneously formed at the same position of the one end of the first outer terminal through stamping.

According to another exemplary embodiment of the disclosure, the first outer terminal is formed with at least one first axial slit in the one end thereof, the at least one first axial slit being adapted to divide the one end of the first outer terminal into a plurality of petals so that the one end of the first outer terminal is formed as a resilient finger with a plurality of petal structures.

According to yet another exemplary embodiment of the disclosure, the one end of the first outer terminal has an end surface abutted against the insulator to prevent the end surface of the one end of the first outer terminal from being in electrical contract with the inner wall of the outer conductor.

According to further another exemplary embodiment of the disclosure, the first receptacle further comprises a first insulation housing in which the first outer terminal, the first center terminal and the first insulation body are held.

According to yet another exemplary embodiment of the disclosure, the first insulation housing is disposed at the one end of the outer conductor and spaced apart therefrom by a predetermined gap to allow the outer conductor is deflectable with respect to an axial direction of the connector assembly by a predetermined angle.

According to still another exemplary embodiment of the disclosure, the predetermined angle is larger than 0 degree and less than 15 degree.

According to another exemplary embodiment of the disclosure, the outer conductor is formed with a conical inner end surface tapered inwardly on the one end thereof. The first insulation housing is formed with a conical outer end surface tapered toward the outer conductor. The conical inner end surface is constructed to face the conical outer end surface and spaced apart therefrom by a predetermined gap.

According to further another exemplary embodiment of the disclosure, when the outer conductor is deflected with respect to an axial direction of the connector assembly by a permissible maximum deflection angle, the one end of the outer conductor is abutted against the conical outer end surface of the first insulation housing to prevent the one end of the outer conductor from being in electrical contact with the first outer terminal.

According to yet another exemplary embodiment of the disclosure, the one end of the center conductor has a cylindrical shape, one end of the first center terminal is inserted into the one end of the center conductor and is brought into electrical contact therewith by sliding.

According to still another exemplary embodiment of the disclosure, the center conductor is formed with at least one first axial slit in the one end thereof, the at least one first axial slit being adapted to divide the one end of the center conductor into a plurality of petals so that the one end of the center conductor is formed as a resilient finger with a plurality of petal structures.

According to another exemplary embodiment of the disclosure, the connector assembly further comprises a second receptacle adapted to be assembled onto the other end of the adaptor in a sliding fit manner.

According to another exemplary embodiment of the disclosure, the second receptacle comprises a cylindrical second outer terminal; a columnar second center terminal disposed in the second outer terminal and a second insulation body disposed between the second outer terminal and the second center terminal to electrically isolate the second outer terminal from the second center terminal. The second outer terminal is formed with a second annular protrusion on an outer wall of one end thereof, the second annular protrusion being adapted to be in electrical contact with the inner wall of the outer conductor of the adaptor through sliding. The outer conductor of the adaptor and the second outer terminal of the second receptacle are in electrical contact with each other only through the second annular protrusion.

According to further another exemplary embodiment of the disclosure, the first receptacle is identical with the second receptacle.

According to yet another exemplary embodiment of the disclosure, the connector assembly is served as a radio frequency coaxial connector assembly

According to another aspect of the disclosure, there is provided an adaptor having one end adapted to be mated with a receptacle. The adaptor comprises a cylindrical outer conductor, a columnar center conductor disposed in the outer conductor, and an insulator disposed between the outer conductor and the center conductor to electrically isolate the outer conductor from the center conductor. The outer conductor is formed with a recess in an inner wall of one end thereof, the recess being adapted to be engaged with an annular protrusion formed on an outer wall of an outer terminal of the receptacle.

According to further another aspect of the disclosure, there is provided a receptacle adapted to be mated onto the one end of the adaptor of the above embodiment. The receptacle comprises a cylindrical outer terminal, a columnar center terminal disposed in the outer terminal, and an insulation body disposed between the outer terminal and the center terminal to electrically isolate the outer terminal from the center terminal. The outer terminal is formed with an annular protrusion on an outer wall of one end thereof, the annular protrusion being adapted to be elastically snap-fit into the recess formed in the inner wall of the outer conductor of the adaptor.

According to yet another aspect of the disclosure, there is provided an adaptor having one end adapted to be mated with a receptacle. The adaptor comprises a cylindrical outer conductor, a columnar center conductor disposed in the outer conductor, and an insulator disposed between the outer conductor and the center conductor to electrically isolate the outer conductor from the center conductor. The insulator is formed with a cylindrical extending portion and an annular protrusion formed on the cylindrical extending portion. The annular protrusion is adapted to be elastically snap-fit into an annular recess formed in an inner wall of an outer terminal of the receptacle.

According to still another aspect of the disclosure, there is provided a receptacle adapted to be mated onto the one end of the adaptor of the above embodiment. The receptacle comprises a cylindrical outer terminal, a columnar center terminal disposed in the outer terminal, and an insulation body disposed between the outer terminal and the center terminal to electrically isolate the outer terminal from the center terminal. The outer terminal is formed with an annular protrusion on an outer wall of one end thereof, the annular protrusion being adapted to be in electrical contact with an inner wall of an outer conductor of the adaptor. The outer terminal is formed with an annular recess in an inner wall of the one end thereof, the annular recess being adapted to be engaged with the annular protrusion formed on the insulator of the adaptor.

In various exemplary embodiments of the disclosure as described above, the outer terminal of the receptacle and the outer conductor of the adaptor are brought into electrical contact with each other only through the annular protrusion. Therefore, it is possible to reduce electrical contact area of the outer conductor of the adaptor and the outer terminal of the receptacle, thereby improving inter-adjustment of the connector assembly.

In addition, in some exemplary embodiments of the disclosure, the insulator of the adaptor is elastically snap-fit with the outer terminal of one receptacle, thereby reliably locking the one end of the adaptor onto the one receptacle.

Other objects and advantages of the present disclosure will become apparent from the following description of the present disclosure when taken in conjunction with the accompanying drawings, and may give a comprehensive understanding of the present disclosure.

### BRIEF DESCRIPTION OF THE DRAWINGS

The above and other features of the present disclosure will become more apparent by describing in detail exemplary embodiments thereof with reference to the accompanying drawings, in which:
Figure 1 illustrates a longitudinal cross-section view of a connector assembly according to an exemplary embodiment of the disclosure;
Figure 2 illustrates a schematic perspective view of an adaptor of the connector assembly shown in Figure 1;
Figure 3 illustrates a partial enlarged view of the connector assembly shown in Figure 1, wherein a locking structure between a first receptacle and the adaptor is shown;
Figure 4 illustrates a schematic perspective view of the first receptacle or a second receptacle of the connector assembly shown in Figure 1;
Figure 5 illustrates a schematic perspective view of a first or second insulator of the adaptor of the connector assembly shown in Figure 1;
Figure 6 illustrates a partial cross-section view of a connector assembly according to another exemplary embodiment of the disclosure;
Figure 7 illustrates a cross-section view of a first receptacle of the connector assembly shown in Figure 6;
Figure 8 illustrates a cross-section view of one end of an adaptor of the connector assembly shown in Figure 6; and
Figure 9 illustrates a schematic perspective view of a first insulator of the adaptor of the connector assembly shown in Figure 6.

### DETAILED DESCRIPTION OF PREFERRED EMBODIMENTS OF THE INVENTION

The technical solution of the present disclosure will be described hereinafter in further detail with reference to the following embodiments, taken in conjunction with the accompanying drawings. In the specification, the same or similar reference numerals indicate the same or similar parts. The description of the embodiments of the present disclosure hereinafter with reference to the accompanying drawings is intended to explain the general inventive concept of the present disclosure and should not be construed as a limitation on the present disclosure.

In addition, in the following detailed description, for the sake of explanation, numerous specific details are set forth in order to provide a thorough understanding of the disclosed embodiments. It will be apparent, however, that one or more embodiments may also be practiced without these specific details. In other instances, well-known structures and devices are illustrated schematically in order to simplify the drawing.

According to an general technical concept of the present disclosure, there is provided a connector assembly comprising an adaptor and a first receptacle adapted to be assembled onto one end of the adaptor. The adaptor comprises a cylindrical outer conductor, a column center conductor disposed in the outer conductor, and an insulator disposed between the outer conductor and the center conductor to electrically isolate the outer conductor from the center conductor. The first receptacle comprises a cylindrical first outer terminal, a column first center terminal disposed in the first outer terminal, and a first insulation body disposed between the first outer terminal and the first center terminal to electrically isolate the first outer terminal from the first center terminal. The first outer terminal is formed with a first annular protrusion on an outer wall of the one end thereof, the annular protrusion being adapted to be in electrical contact with an inner wall of the outer conductor of the adaptor. The outer conductor of the adaptor and the first outer terminal of the first receptacle are in electrical contact with each other only through the first annular protrusion.

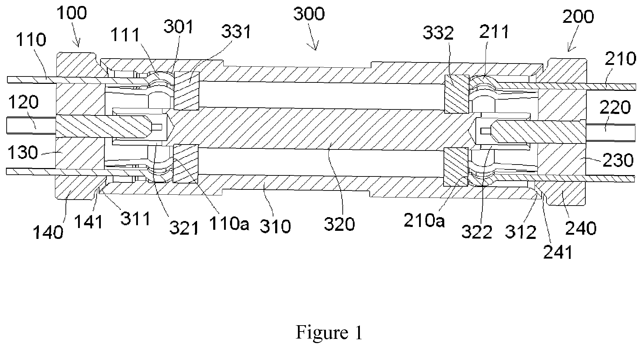

Figure 1 illustrates a longitudinal cross-section view of a connector assembly according to an exemplary embodiment of the disclosure.

As shown in Figure 1, in the illustrated embodiment, the connector assembly comprises an adaptor 300, and a first receptacle 100 adapted to be assembled onto one end of the adaptor 300.

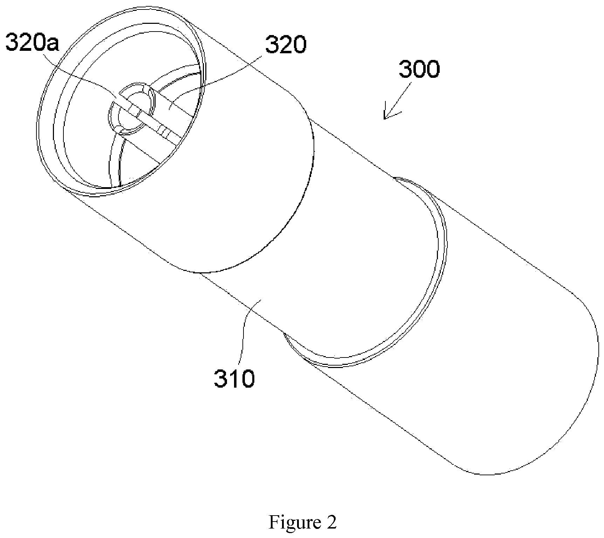

Figure 2 illustrates a schematic perspective view of the adaptor 300 of the connector assembly shown in Figure 1.

As shown in Figures 1 and 2, in the illustrated embodiment, the adaptor 300 mainly comprises a cylindrical outer conductor 310, a column center conductor 320 disposed in the outer conductor 310, and an insulator 331, 332 disposed between the outer conductor 310 and the center conductor 320 to electrically isolate the outer conductor 310 from the center conductor 320.

As shown in Figure 1, in the illustrated embodiment, the insulator 331, 332 of the adaptor 300 comprises a first insulator 331 mounted on one end 321 of the center conductor 320 and a second insulator 332 mounted on the other end 322 of the center conductor 320. Both ends of the center conductor 320 are supported and held on the first insulator 321 and the second insulator 322, respectively.

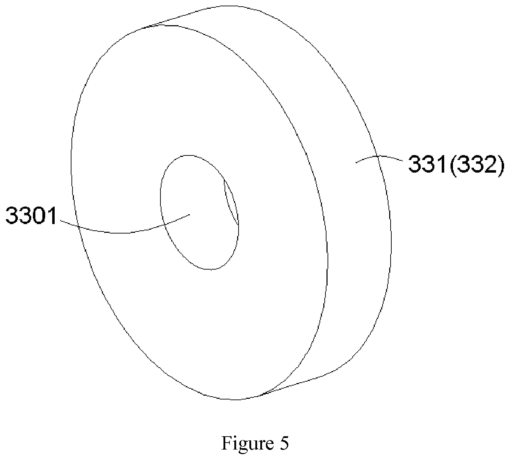

Figure 5 illustrates a schematic perspective view of the first insulator 331 or the second insulator 332 of the adaptor 300 of the connector assembly shown in Figure 1.

As shown in Figure 5, the first insulator 331 and the second insulator 332 each has a column shape and is formed with an axial positioning hole 3301 therein. Both ends 321, 322 of the center conductor 320 are fit into the axial positioning holes 3301 of the first insulator 331 and the second insulator 332, respectively.

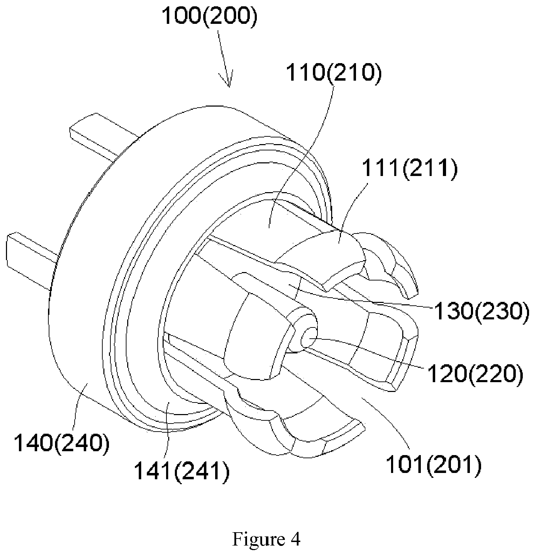

Figure 4 illustrates a schematic perspective view of the first receptacle 100 of the connector assembly shown in Figure 1.

As shown in Figures 1 and 4, in the illustrated embodiment, the first receptacle 100 comprises a cylindrical first outer terminal 110, a column first center terminal 120 disposed in the first outer terminal 110, and a first insulation body 130 disposed between the first outer terminal 110 and the first center terminal 120 to electrically isolate the first outer terminal 110 from the first center terminal 120.

As shown in Figure 1, in the illustrated embodiment, the first outer terminal 110 is formed with a first annular protrusion 111 on an outer wall of one end thereof. The first annular protrusion 111 is brought into electrical contact with an inner wall of the outer conductor 310 of the adaptor 300. Further, the outer conductor 310 of the adaptor 300 and the first outer terminal 110 of the first receptacle 100 are in electrical contact with each other only through the first annular protrusion 111.

In an exemplary embodiment of the disclosure, the first receptacle 100 is adapted to be locked onto the one end of the adaptor 300.

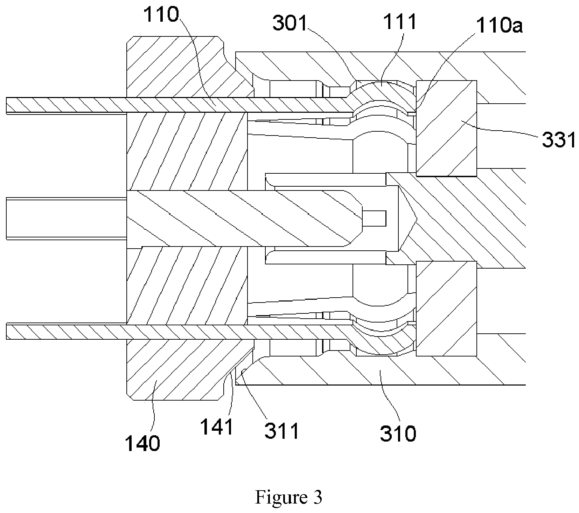

Figure 3 illustrates a partial enlarged view of the connector assembly shown in Figure 1, wherein a locking structure between the first receptacle 100 and the adaptor 300 is shown.

As shown in Figures 1 and 3, in the illustrated embodiment, the outer conductor 310 of the adaptor 300 is formed with a recess 301 in an inner wall of one end thereof. The first annular protrusion 111 on the outer terminal 110 of the first receptacle 100 is adapted to be elastically snap-fit into the recess 301 to lock the first receptacle 100 onto the one end of the adaptor 300.

As shown in Figure 4, in the illustrated embodiment, the first outer terminal 110 is formed with at least one first axial slit 101 in one end thereof The at least one first axial slit 101 divides the one end of the first outer terminal 110 into a plurality of petals so that the one end of the first outer terminal 110 is formed as a resilient finger with a plurality of petal structures. A free end of each petal is formed as an arc protrusion protruding outwardly, and a plurality of arc protrusions of the plurality of petals are formed as the first annular protrusion.

As shown in Figure 3, in the illustrated embodiment, the one end of the first outer terminal 110 has an end surface 110a abutted against the insulators 331, 332 to prevent the end surface 110a of the one end of the first outer terminal 110 from being in electrical contract with the inner wall of the outer conductor 310. In this way, the outer conductor 310 of the adaptor 300 and the first outer terminal 110 of the first receptacle 100 are brought into electrical contact with each other only through the first annular protrusion 111.

As shown in Figures 3 and 4, in the illustrated embodiment, the first receptacle 100 further comprises a first insulation housing 140 in which the first outer terminal 110, the first center terminal 120 and the first insulation body 130 are held.

As shown in Figures 1 and 3, in the illustrated embodiment, the first insulation housing 140 is disposed at the one end of the outer conductor 310 and spaced apart therefrom by a predetermined gap to allow the outer conductor 310 is deflectable with respect to an axial direction of the connector assembly by a predetermined angle. In an exemplary embodiment of the disclosure, the predetermined angle is larger than 0 degree and less than 15 degree, preferably, the predetermined angle is larger than 0 degree and less than 10 degree, and more preferably, the predetermined angle is larger than 0 degree and less than 5 degree.

As shown in Figures 1 and 3, in the illustrated embodiment, the outer conductor 310 is formed with a circle of conical inner end surface 311 tapered inwardly at the one end thereof, and the first insulation housing 140 is formed with a conical outer end surface 141 tapered toward the outer conductor 310. The conical inner end surface 311 is constructed to face the conical outer end surface 140 and spaced apart therefrom by the predetermined gap.

In an exemplary embodiment of the disclosure, when the outer conductor 310 is deflected with respect to the axial direction of the connector assembly by a permissible maximum deflection angle, the conical inner end surface 311 of the outer conductor 310 is abutted against the conical outer end surface 141 of the first insulation housing 140 to prevent the one end of the outer conductor 310 from being in electrical contact with the first outer terminal 110. In this way, the outer conductor 310 and the first outer terminal 110 are brought into electrical contact with each other only through the first annular protrusion 111.

As shown in Figures 1 and 2, in the illustrated embodiment, the one end 321 of the center conductor 320 is formed as a cylindrical shape, and one end of the first center terminal 120 is inserted into the one end 321 of the center conductor 320 with in electrical contact therewith by sliding.

As shown in Figures 1 and 2, in the illustrated embodiment, the center conductor 320 is formed with at least one axial slit 320a in the one end 321 thereof. The at least one axial slit 320a is adapted to divide the one end 321 of the center conductor 320 into a plurality of petals so that the one end 321 of the center conductor 320 is formed as a resilient finger with the plurality of petal structures.

As shown in Figures 1 and 4, in the illustrated embodiment, the connector assembly further comprises a second receptacle 200 adapted to be assembly onto the other end of the adaptor 300 in a sliding fit manner.

As shown in Figures 1 and 4, in the illustrated embodiment, the second receptacle 200 comprises a cylindrical second outer terminal 210, a columnar second center terminal 220 disposed in the second outer terminal 210, and a second insulation body 230 disposed between the second outer terminal 210 and the second center terminal 220 to electrically isolate the second outer terminal 210 from the second center terminal 220. The second outer terminal 210 is formed with a second annular protrusion 211 on an outer wall of one end thereof. The second annular protrusion 211 is brought into electrical contact with the inner wall of the outer conductor 310 of the adaptor 300 through sliding. Further, the outer conductor 310 of the adaptor 300 and the second outer terminal 210 of the second receptacle 200 are in electrical contact with each other only through the second annular protrusion 211.

As shown in Figure 4, in the illustrated embodiment, the second outer terminal 210 is formed with at least one second axial slit 201 in the one end thereof. The at least one second axial slit 201 is adapted to divide the one end of the second outer terminal 210 into a plurality of petals so that the one end of the second outer terminal 210 is formed as a resilient finger with a plurality of petal structures. A free end of each petal is formed as an arc protrusion protruding outwardly, and a plurality of arc protrusions of the plurality of petals are formed as the second annular protrusion.

As shown in Figure 1, in the illustrated embodiment, the one end of the second outer terminal 210 has an end surface 210a abutted against the insulator 322 of the adaptor 300 to prevent the end surface 210a of the one end of the second outer terminal 210 from being in electrical contact with the inner wall of the outer conductor 310. In this way, the outer conductor 310 of the adaptor 300 and the second outer terminal 210 of the second receptacle 200 are in electrical contact with each other only through the second annular protrusion 211.

As shown in Figures 1 and 4, in the illustrated embodiment, the second receptacle 200 further comprises a second insulation housing 240 in which the second outer terminal 210, the second center terminal 220 and the second insulation body 230 are held.

As shown in Figures 1 and 4, in the illustrated embodiment, the second insulation housing 240 is disposed at the other end of the outer conductor 310 and spaced apart therefrom by a predetermined gap to allow the outer conductor 310 is deflectable with respect to the axial direction of the connector assembly by a predetermined angle. In an exemplary embodiment of the disclosure, the predetermined angle is larger than 0 degree and less than 15 degree, preferably, the predetermined angle is larger than 0 degree and less than 10 degree, and more preferably, the predetermined angle is larger than 0 degree and less than 5 degree.

As shown in Figures 1 and 4, in the illustrated embodiment, the outer conductor 310 is formed with a circle of conical inner end surface 312 tapered inwardly at the other end thereof, and the second insulation housing 240 is formed with a conical outer end surface 241 tapered toward the outer conductor 310. The conical inner end surface 312 is constructed to face the conical outer end surface 241 and spaced apart therefrom by a predetermined gap.

As shown in Figures 1 and 4, in the illustrated embodiment, when the outer conductor 310 is deflected with respect to the axial direction of the connector assembly by a permissible maximum deflection angle, the conical inner end surface 312 of the outer conductor 310 is abutted against the conical outer end surface 241 of the second insulation housing 240 to prevent the other end of the outer conductor 310 from being in electrical contact with the second outer terminal 210. In this way, the outer conductor 310 of the adaptor 300 and the second outer terminal 210 of the second receptacle 200 are brought into electrical contact with each other only through the second annular protrusion 211.

As shown in Figures 1 and 2, in the illustrated embodiment, the other end 321 of the center conductor 320 is formed as a cylindrical shape, and one end of the second center terminal 220 is inserted into the other end 322 of the center conductor 320 and is in electrical contact therewith through sliding.

As shown in Figures 1 and 2, in the illustrated embodiment, the center conductor 320 is formed with at least one axial slit 320a in the other end 322 thereof. The at least one axial slit 320a is adapted to divide the other end 322 of the center conductor 320 into a plurality of petals so that the other end 322 of the center conductor 320 is formed as a resilient finger with the plurality of petal structures.

In an exemplary embodiment of the disclosure, as shown in Figure 4, the first outer terminal 110 and the second outer terminal 210 each is a stamping part formed by a stamping process.

In an exemplary embodiment of the disclosure, as shown in Figure 4, the first insulation body 130, the second insulation body 230, the first insulation housing 140 and the second insulation housing 240 each is an injection molded part formed by an injection molding process.

In an exemplary embodiment of the disclosure, as shown in Figures 1 and 4, the first receptacle 100 is identical with the second receptacle 200.

In an exemplary embodiment of the disclosure, as shown in Figure 1, the connector assembly may include a radio frequency (RF) coaxial connector assembly. The RF coaxial connector is adapted to connect two circuit boards so that a RF signal may be transmitted from one circuit board to the other circuit board via the RF coaxial connector assembly.

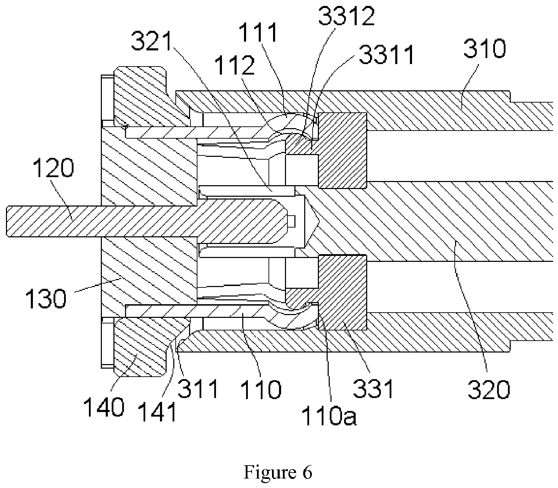

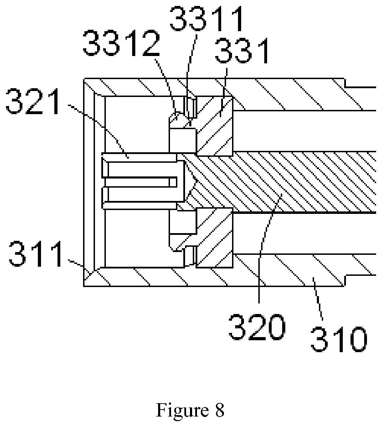

It is noted that, in the present disclosure, the locking structure between the first receptacle 100 and the adapter 300 is not limited to the embodiment shown in Figure 3. For example, Figures 6 to 9 show another embodiment of the locking structure between the first receptacle 100 and the adapter 300.

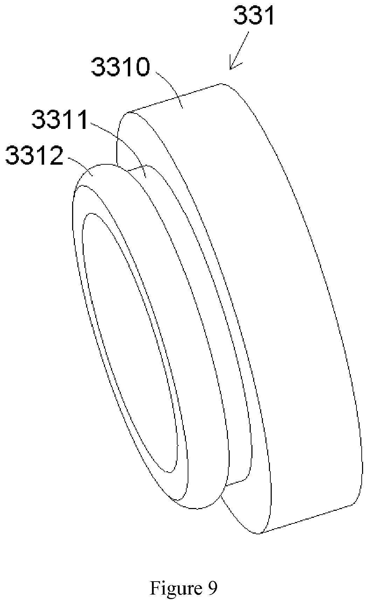

Figure 6 illustrates a partial cross-section view of a connector assembly 300 according to another exemplary embodiment of the disclosure, and Figure 9 illustrates a schematic perspective view of a first insulator 310 of the adaptor 300 of the connector assembly shown in Figure 6.

In another exemplary embodiment of the disclosure, as shown in Figures 6 and 9, the insulator 331 of the adapter 300 comprises a column main body 3310, a cylindrical extending portion 3311 extending from the column main body3310 and an annular protrusion 3312 formed on a free end of the cylindrical extending portion 3311.

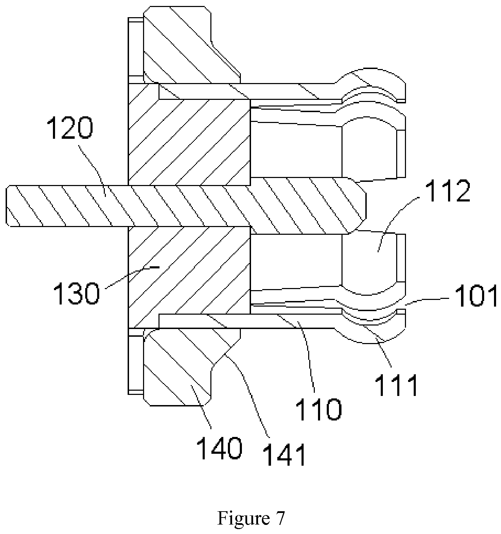

As shown in Figs. 6 and 7, the first outer terminal 110 is formed with an annular recess 112 protruding outwardly in an inner wall of one end thereof. The annular protrusion 3312 is adapted to be elastically snap-fit into the annular recess 112 to lock the first receptacle 100 onto the one end of the adaptor 300.

In this embodiment, since the insulator 331 of the adaptor is typically made of plastic material, the manufacture thereof is easy and has low cost. Therefore, it is possible to reduce the manufacture cost of the connector assembly.

As shown in Figure 7, in the illustrated embodiment, the first annular protrusion 111 on the one end of the first outer terminal 110 is opposite to the annular recess 112 in a radial direction of the first outer terminal 110. In an exemplary embodiment of the disclosure, the annular protrusion 111 and the annular recess 112 may be formed at the same position of the one end of the first outer conductor 100 through stamping.

In an exemplary embodiment of the disclosure, the connector assembly shown in Figures 1 and 6 may be served as a radio frequency (RF) coaxial connector assembly adapted to be connected between two circuit boards.

According to an exemplary embodiment of the disclosure, there is provided an adaptor 300 having one end adapted to be mated with a receptacle 100. The adapter 300 mainly comprises a cylindrical outer conductor 310, a columnar center conductor 320 disposed in the outer conductor 310, and an insulator 331, 332 disposed between the outer conductor 310 and the center conductor 320 to electrically isolate the outer conductor 310 from the center conductor 320. The outer conductor 310 of the adaptor 300 is formed with a recess 301 in an inner wall of one end thereof. The recess 301 is adapted to be engaged with an annular protrusion 111 formed on an outer wall of an outer terminal 110 of the receptacle 100.

In another exemplary embodiment of the disclosure, there is disclosed a receptacle 100 adapted to be mated onto the one end of the adaptor 300. The receptacle 100 mainly comprises a cylindrical outer terminal 110, a columnar center terminal 120 disposed in the outer terminal 110, and an insulation body 130 disposed between the outer terminal 110 and the center terminal 120 to electrically isolate the outer terminal 110 from the center terminal 120. The outer terminal 110 is formed with an annular protrusion 111 on an outer wall of one end thereof. The annular protrusion 111 is adapted to be elastically snap-fit into the recess 301 formed in the inner wall of the outer conductor 310 of the adaptor 300.

In further another exemplary embodiment of the disclosure, there is provided an adaptor having one end adapted to be mated with a receptacle 100. The adapter 300 mainly comprises a cylindrical outer conductor 310, a columnar center conductor 320 disposed in the outer conductor 310, and an insulator 331 disposed between the outer conductor 310 and the center conductor 320 to electrically isolate the outer conductor 310 from the center conductor 320. The insulator 331 is formed with a cylindrical extending portion 3311 and an annular protrusion 3312 formed on the cylindrical extending portion 3311. The annular protrusion 3312 is adapted to be elastically snap-fit into an annular recess 112 formed in an inner wall of an outer terminal 110 of the receptacle 100.

In still another exemplary embodiment of the disclosure, there is provided a receptacle adapted to be mated onto the one end of the adaptor 300. The receptacle 100 mainly comprises a cylindrical outer terminal 110, a columnar center terminal 120 disposed in the outer terminal 110, and an insulation body 130 disposed between the outer terminal 110 and the center terminal 120 to electrically isolate the outer terminal 110 from the center terminal 120. The outer terminal 110 is formed with an annular protrusion 111 on an outer wall of one end thereof and an annular recess 112 in an inner wall of the one end thereof. The annular protrusion 111 is adapted to be in electrical contact with an inner wall of an outer conductor 310 of the adaptor 300, and the annular recess 112 is adapted to be engaged with the annular protrusion 3312 formed on the insulator 331 of the adaptor 300.

It should be appreciated by those skilled in this art that the above embodiments are intended to be illustrative, and many modifications may be made to the above embodiments by those skilled in this art, and various structures described in various embodiments may be freely combined with each other without conflicting in configuration or principle.

Although the present disclosure have been described hereinbefore in detail with reference to the attached drawings, it should be appreciated that the disclosed embodiments in the attached drawings are intended to illustrate the preferred embodiments of the present disclosure by way of example, and should not be construed as limitation to the present disclosure.

Although several exemplary embodiments have been shown and described, it would be appreciated by those skilled in the art that various changes or modifications may be made to these embodiments without departing from the principles and spirit of the disclosure, the scope of which is defined by the claims and their equivalents.

It should be noted that, the word "comprise" doesn't exclude other elements or steps, and the word "a" or "an" doesn't exclude more than one. In addition, any reference numerals in the claims should not be interpreted as the limitation to the scope of the present disclosure.

## Claims

1. A connector assembly, comprising:
an adaptor (300) comprising:
a cylindrical outer conductor (310);
a column center conductor (320) disposed in the outer conductor (310); and
an insulator (331, 332) disposed between the outer conductor (310) and the center conductor (320) to electrically isolate the outer conductor (310) from the center conductor (320), and
a first receptacle (100) adapted to be assembled onto one end of the adaptor (300) and comprising:
a cylindrical first outer terminal (110);
a column first center terminal (120) disposed in the first outer terminal (110); and
a first insulation body (130) disposed between the first outer terminal (110) and the first center terminal (120) to electrically isolate the first outer terminal (110) from the first center terminal (120),
wherein the first outer terminal (110) is formed with a first annular protrusion (111) on an outer wall of one end thereof, the annular protrusion (111) being adapted to be in electrical contact with an inner wall of the outer conductor (310) of the adaptor (300); and
wherein the outer conductor (310) of the adaptor (300) and the first outer terminal (110) of the first receptacle (100) are in electrical contact with each other only through the first annular protrusion (111).

2. The connector assembly according to claim 1, wherein the first receptacle (100) is adapted to be locked onto the one end of the adaptor (300).

3. The connector assembly according to claim 2, wherein the outer conductor (310) of the adaptor (300) is formed with a recess (301) in an inner wall of one end thereof, and the first annular protrusion (111) on the outer terminal (110) of the first receptacle (100) is adapted to be elastically snap-fit into the recess (301) to lock the first receptacle (100) onto the one end of the adaptor (300).

4. The connector assembly according to one of claims 2 or 3, wherein the insulator (331,332) of the adaptor (300) is formed with a cylindrical extending portion (3311) and an annular protrusion (3312) formed on the cylindrical extending portion (3311); and
wherein the outer terminal (110) is formed with an annular recess (112) in an inner wall of the one end thereof, and the annular protrusion (3312) is adapted to be elastically snap-fit into the annular recess (112) to lock the first receptacle (100) onto the one end of the adaptor (300).

5. The connector assembly according to claim 4, wherein the annular protrusion (111) on the one end of the first outer terminal (110) is opposite to the annular recess (112) in a radial direction of the first outer terminal (110); and
wherein the annular protrusion (111) and the annular recess (112) are simultaneously formed at the same position of the one end of the first outer terminal (100) through stamping.

6. The connector assembly according to one of claims 1 to 5, wherein,
the first outer terminal (110) is formed with at least one first axial slit (101) in the one end thereof, the at least one first axial slit (101) being adapted to divide the one end of the first outer terminal (110) into a plurality of petals so that the one end of the first outer terminal (110) is formed as a resilient finger with a plurality of petal structures.

7. The connector assembly according to one of claims 1 to 6, wherein the one end of the first outer terminal (110) has an end surface (110a) abutted against the insulator (331, 332) to prevent the end surface (110a) of the one end of the first outer terminal (110) from being in electrical contract with the inner wall of the outer conductor (310).

8. The connector assembly according to one of claims 1 to 7, wherein the first receptacle (100) further comprises a first insulation housing (140) in which the first outer terminal (110), the first center terminal (120) and the first insulation body (130) are held.

9. The connector assembly according to claim 8, wherein the first insulation housing (140) is disposed at the one end of the outer conductor (310) and spaced apart therefrom by a predetermined gap to allow the outer conductor (310) is deflectable with respect to an axial direction of the connector assembly by a predetermined angle.

10. The connector assembly according to claim 9, wherein the predetermined angle is larger than 0 degree and less than 15 degree.

11. The connector assembly according to one of claims 9 or 10, wherein the outer conductor (310) is formed with a conical inner end surface (311) tapered inwardly on the one end thereof; the first insulation housing (140) is formed with a conical outer end surface (141) tapered toward the outer conductor (310); and the conical inner end surface (311) is constructed to face the conical outer end surface (140) and spaced apart therefrom by a predetermined gap.

12. The connector assembly according to claim 11, wherein when the outer conductor (310) is deflected with respect to an axial direction of the connector assembly by a permissible maximum deflection angle, the conical inner end surface of the outer conductor (310) is abutted against the conical outer end surface (141) of the first insulation housing (140) to prevent the one end of the outer conductor (310) from being in electrical contact with the first outer terminal (110).

13. The connector assembly according to one of claims 1 to 12, wherein the one end (321) of the center conductor (320) has a cylindrical shape; and one end of the first center terminal (120) is inserted into the one end (321) of the center conductor (320) and is brought into electrical contact with the one end (321) of the center conductor (320) by sliding.

14. The connector assembly according to claim 13, wherein the center conductor (320) is formed with at least one first axial slit (320a) in the one end (321) thereof, the at least one first axial slit (320a) being adapted to divide the one end (321) of the center conductor (320) into a plurality of petals so that the one end (321) of the center conductor (320) is formed as a resilient finger with a plurality of petal structures.

15. The connector assembly according to one of claims 1 to 14, further comprising a second receptacle (200) adapted to be assembled onto the other end of the adaptor (300) in a sliding fit manner.

16. The connector assembly according to claim 15, wherein
the second receptacle (200) comprises:
a cylindrical second outer terminal (210);
a columnar second center terminal (220) disposed in the second outer terminal (210); and
a second insulation body (230) disposed between the second outer terminal (210) and the second center terminal (220) to electrically isolate the second outer terminal (210) from the second center terminal (220),
wherein the second outer terminal (210) is formed with a second annular protrusion (211) on an outer wall of one end thereof, the second annular protrusion 211 being adapted to be in electrical contact with the inner wall of the outer conductor (310) of the adaptor (300) through sliding; and
wherein the outer conductor (310) of the adaptor (300) and the second outer terminal (210) of the second receptacle (200) are in electrical contact with each other only through the second annular protrusion (211).

17. The connector assembly according to claim 16, wherein the first receptacle (100) is identical with the second receptacle (200).

18. The connector assembly according to one of claims 1 to 17, wherein the connector assembly is served as a radio frequency coaxial connector assembly

19. An adaptor having one end adapted to be mated with a receptacle (100), comprising:
a cylindrical outer conductor (310);
a columnar center conductor (320) disposed in the outer conductor (310); and
an insulator (331, 332) disposed between the outer conductor (310) and the center conductor (320) to electrically isolate the outer conductor (310) from the center conductor (320),
wherein the outer conductor (310) is formed with a recess (301) in an inner wall of one end thereof.

20. A receptacle adapted to be mated onto the one end of the adaptor (300) according to claim 19, comprising:
a cylindrical outer terminal (110);
a columnar center terminal (120) disposed in the outer terminal (110); and
an insulation body (130) disposed between the outer terminal (110) and the center terminal (120) to electrically isolate the outer terminal (110) from the center terminal (120),
wherein the outer terminal (110) is formed with an annular protrusion (111) on an outer wall of one end thereof, the annular protrusion (111) being adapted to be elastically snap-fit into the recess (301) formed in the inner wall of the outer conductor (310) of the adaptor (300).

21. An adaptor having one end adapted to be mated with a receptacle (100), comprising:
a cylindrical outer conductor (310);
a columnar center conductor (320) disposed in the outer conductor (310); and
an insulator (331) disposed between the outer conductor (310) and the center conductor (320) to electrically isolate the outer conductor (310) from the center conductor (320),
wherein the insulator (331) is formed with a cylindrical extending portion (3311) and an annular protrusion (3312) formed on the cylindrical extending portion (3311).

22. A receptacle adapted to be mated onto the one end of the adaptor (300) according to claim 21, comprising:
a cylindrical outer terminal (110);
a columnar center terminal (120) disposed in the outer terminal (110); and
an insulation body (130) disposed between the outer terminal (110) and the center terminal (120) to electrically isolate the outer terminal (110) from the center terminal (120),
wherein the outer terminal (110) is formed with an annular protrusion (111) on an outer wall of one end thereof, the annular protrusion (111) being adapted to be in electrical contact with an inner wall of an outer conductor (310) of the adaptor (300); and
wherein the outer terminal (110) is formed with an annular recess (112) in an inner wall of the one end thereof, the annular recess (112) being adapted to be engaged with the annular protrusion (3312) formed on the insulator (331) of the adaptor (300).
